# EUROPÄISCHE PATENTSCHRIFT

(11) **EP 0 574 687 B1**
(45) Veröffentlichungstag und Bekanntmachung des Hinweises auf die Patenterteilung: **08.04.1998**
(21) Anmeldenummer: 93107221.9
(22) Anmeldetag: 04.05.1993
(51) Int. Cl.: H01L 21/285, H01L 21/3205

(54) **Verfahren zur Herstellung einer planaren Al-haltigen Schicht auf einem Substrat mit Lochstrukturen an der Oberfläche**
Method of depositing a planar layer containing aluminium on a substrate with a hole structure in its surface
Procédé de dépôt d'une couche plane contenant de l'aluminium sur un substrat comportant des trous à sa surface

(30) Priorität: 20.05.1992 DE 4216715
(43) Veröffentlichungstag der Anmeldung: 22.12.1993
(73) Patentinhaber: SIEMENS AKTIENGESELLSCHAFT, 80333 München (DE)
(72) Erfinder: Willer, Josef, Dr., W-8012 Riemerling (DE); Wendt, Hermann, Dr., W-8011 Neukeferloh (DE); Lehmann, Volker, Dr., W-8000 München 21 (DE)

(56) Entgegenhaltungen:
- EP-A- 0 296 348
- EP-A- 0 376 709
- SOLID STATE TECHNOLOGY, Bd. 22, Nr. 12, Dezember 1979, Washington US, Seiten 66-72; L.D. HARTSOUGH et al.: 'Aluminium and aluminium alloy sputter deposition for VLSI'
- PROCEEDINGS OF THE THIRD INTERNATIONAL IEEE VLSI MULTILEVEL INTERCONNECTION CONFERENCE, 9. Juni 1986, Santa Clara CA, Seiten 212-218; M.A. LARDON et al.: 'Metallization of high aspect microstructures with a multiple cycle evaporation/sputter etching process'

## Beschreibung

Die Erfindung betrifft ein Verfahren zur Herstellung einer Al-haltigen Schicht mit einer planaren Oberfläche auf einem Substrat mit Lochstrukturen mit einem hohen Aspektverhältnis in der Oberfläche.

Unter Aspektverhältnis versteht man den quotienten Tiefe/Durchmesser einer Lochstruktur.

Für verschiedene Anwendungen ist es erforderlich, an der Oberfläche von Substraten mit Lochstrukturen mit einem hohen Aspektverhältnis in der Oberfläche Schichten zu erzeugen, die die Lochstrukturen verschließen und die eine planare Oberfläche aufweisen. Lochstrukturen mit einem hohen Aspektverhältnis, d. h. mit einem Aspektverhältnis von mindestens 10, insbesondere 50 bis 200, lassen sich in Sputterverfahren nicht auffüllen. Es ist lediglich möglich, an der Oberfläche eine Schicht zu erzeugen, die die Lochstrukturen verschließt. Insbesondere zur Kontaktierung von in solchen Substraten angeordneten Bauelementen ist es erforderlich, eine planare Al-haltige Schicht zu erzeugen. Diese muß planar sein, um mit gängigen Anschlußtechniken wie z. B. Wire-bonding kompatibel zu sein.

Al-haltige Schichten werden gewöhnlich durch Aufdampfen oder Aufstäuben abgeschieden. Um auf Silizium-Halbleitermaterialien sperrfreie, niederohmige Kontakte herzustellen, werden die zu kontaktierenden Substrate mit einer Titanschicht und mit einer TiN-Diffusionsbarriere versehen. Darauf wird die Al-haltige Schicht abgeschieden.

Aus der Literatur (s. z. B. Proceed-ings of the International IEEE VLSI Multilevel Interconnection Conference 5 (1988), pp. 76 - 84; JP 2-68 926 (A); EP 0 485 130 A2; EP 0 430 403 A2) ist bekannt, Kontaktlöcher aufzufüllen, so daß die Füllung eine planare Oberfläche aufweist. Kontaktlöcher weisen Aspektverhältnisse von etwa 1, höchstens 5 auf. Ferner besteht die Seitenwand eines Kontaktloches aus einem Isolator. Beim Auffüllen von Kontaktlöchern ist es das Ziel, das Kontaktloch vollständig mit leitfähigem Material zu füllen, um einen Stromfluß vom Boden des Kontaktloches zur Oberfläche der Kontaktlochfüllung durch einen möglichst niederohmigen Leiter sicherzustellen. Bei der Kontaktlochauffüllung spielt der Effekt der Benetzung eine wesentliche Rolle. Dazu wird am Boden und auf der Seitenwand des Kontaktloches Titan-haltige Schicht aufgebracht. Zwischen der Titan-haltigen Schicht und dem abgeschiedenen Aluminium findet eine Ti-Al-Reaktion statt, durch die Adhäsionskräfte wirksam werden. Die Adhäsionskräfte übertreffen die Kohäsion des Aluminiums. Dadurch werden die Aluminiumatome an den Boden des mit einer Titan-haltigen Schicht bedeckten Kontaktloches gezogen.

Wird auf ein Substrat mit Lochstrukturen mit hohem Aspektverhältnis in der Oberfläche durch Aufdampfen oder Aufstäuben eine Al-haltige Schicht abgeschieden, so werden die Lochstrukturen selbst wenn ihr Durchmesser kleiner als 2 µm ist, bei Schichtdicken bis zu 5 µm nicht verschlossen. Die aluminiumhaltige Schicht schlägt sich auf den Trennwänden der Lochstrukturen nieder. Dadurch verjüngern sich die Zylinderöffnungen der Lochstrukturen mit zunehmender Schichtdicke. Zum Verschließen der Lochstrukturen sind jedoch erheblich größere Schichtdicken als 5 µm erforderlich. Bei Schichtdicken von 1 µm bis 3 µm ist auf diese Weise keine geschlossene planare Oberfläche zu erreichen.

Der Erfindung liegt daher die Aufgabe zugrunde, ein Verfahren anzugeben zur Herstellung einer planaren Al-haltigen Schicht auf einem Substrat mit Lochstrukturen an der Oberfläche, mit dem auch bei Schichtdicken von etwa 1 µm bis 3 µm eine planare Oberfläche erzielt wird.

Das Problem wird erfindungsgemäß gelöst durch ein Verfahren nach Anspruch 1. Unter dem Begriff hohes Aspektverhältnis wird ein Aspektverhältnis von mindestens 10 verstanden. Das erfindungsgemäße Verfahren ist besonders vorteilhaft einsetzbar für Aspektverhältnisse zwischen 50 und 200 und Lochdurchmessern zwischen 0,1 und 2 µm.

Mit dem erfindungsgemäßen Verfahren können Aluminium-haltige Schichten auf Substraten hergestellt werden, die Lochstrukturen mit einem hohen Aspektverhältnis aufweisen. Diese Lochstrukturen sind für den Kontakt, der durch die Aluminium-haltige Schicht realisiert wird, nicht erforderlich. Aus prozeßtechnischen oder anwendungsspezifischen Gründen können diese Lochstrukturen jedoch unvermeidbar sein.

Dies gilt insbesondere für monokristalline Silizium-substrate, deren Oberfläche durch elektrochemisches Ätzen in einem fluoridhaltigen, sauren Elektrolyten vergrößert ist.

Ist die Oberfläche der Lochstrukturen leitfähig, weil sie z. B. aus dotiertem Silizium oder dotiertem Polysilizium besteht, so ist es zur Herstellung einer Kontaktschicht ausreichend, eine planare, durchgehende, die Lochöffnungen der Lochstruktur verschließende, Aluminium-haltige Schicht herzustellen. Bei großen Aspektverhältnissen kann dabei ein Auffüllen der Löcher nicht erfolgen, da die Löcher für das Abscheideverfahren als unendlich tief anzusehen sind. Ein Auffüllen der Löcher ist in diesem Fall auch nicht erforderlich, da ein Stromfluß über die Oberfläche der Lochstrukturen zu der Aluminium-haltigen Schicht erfolgt.

In dem erfindungsgemäßen Verfahren wird die Aluminium-haltige Schicht durch Sputtern hergestellt. Beim Sputtern bildet sich an der zur Ausdehnung des Substrats parallelen Oberfläche eine von der Sputterdauer abhängige Schichtdicke, die an dazu senkrechten Flanken der Lochstrukturen aufgrund der Winkelverteilung der einfallenden Atome abnimmt. Es wurde festgestellt, daß die Atome der wachsenden Schicht ohne zusätzliche Maßnahmen nur eine unzureichende Oberflächenbeweglichkeit aufweisen, so daß ein Loch wegen der Abschattung der einen Kante durch die gegenüberliegende nicht zuwächst. Erst durch die erhöhte Temperatur, bei der erfindungsgemäß die Abscheidung der Aluminium-haltigen Schicht erfolgt, tritt eine gesteigerte Atombeweglichkeit in der wachsenden Schicht auf, so daß durch Zusammenwachsen der Schicht über die Löcher die Oberfläche minimiert wird. Auf diese Weise ergibt sich in dem erfindungsgemäßen Verfahren schon bei einer geringen Schichtdicke von 1 bis 3 µm der Aluminium-haltigen Schicht eine geschlossene, planare Oberfläche.

In Folge der erhöhten Substrattemperatur und des geringen Restgaspartialdruckes beim Abscheiden der aluminiumhaltigen Schicht ist die Oberflächenbeweglichkeit erhöht. Dadurch wird eine Minimierung der Oberflächenenergie ermöglicht, so daß sich die Lochöffnungen schließen können. Dieser Mechanismus funktioniert insbesondere dann, wenn die Kohäsionskräfte innerhalb der aluminiumhaltigen Schicht die Adhäsionskräfte zur Unterlage übertreffen.

Vorzugsweise wird das Substrat während der Abscheidung der aluminiumhaltigen Schicht auf einer Temperatur zwischen etwa 400 °C und 500 °C gehalten. Ein Temperschritt bei einer Temperatur in dieser Größenordnung ist bei bekannten Verfahren zur Herstellung von aluminiumhaltigen Schichten im Anschluß an die Schichtabscheidung in der Regel erforderlich. Daher bedeutet das Sputtern bei einer Substrattemperatur von etwa 400 bis 500 °C keine zusätzliche Temperaturbelastung für die Struktur. Der nachträgliche Temperschritt kann in dem erfindungsgemäßen Verfahren jedoch entfallen. Das bedeutet eine Vereinfachung der Prozeßfolge.

Es liegt im Rahmen der Erfindung, daß im Vakuum ein Restgaspartialdruck von weniger als 1,3 x 10⁻⁵ Pa (10⁻⁷Torr) herrscht. Da die Teilchenbeweglichkeit mit abnehmendem Restgasanteil zunimmt, kann im Fall eines sehr guten Vakuums, wie es z. B. in einer UHV-Sputteranlage sichergestellt ist, die nötige Substrattemperatur bei der Abscheidung der aluminiumhaltigen Schicht etwas gesenkt werden. Insbesondere wenn das Substrat an der Oberfläche monokristallines oder polykristallines Silizium aufweist, ist es vorteilhaft, zur Abscheidung der aluminiumhaltigen Schicht eine möglichst geringe Substrattemperatur zu verwenden, da bei höheren Temperaturen es zu einer stärkeren Spikebildung des Aluminiums auf der Siliziumunterlage kommt.

Es liegt im Rahmen der Erfindung, auf dem Substrat zunächst eine Zwischenschicht aus Titan und eine Barriereschicht aus TiN abzuscheiden, auf die die aluminiumhaltige Schicht abgeschieden wird. Die Zwischenschicht und die Barriereschicht verhindern das befürchtete Spiking des Aluminiums auf einer Siliziumunterlage, das zum Ausfall von Bauelementen führen kann. Die Zwischenschicht und die Barriereschicht werden dabei auf den Zwischenwänden zwischen den Lochstrukturen abgeschieden. Sie bilden keine durchgehende Schicht. Wegen des großen Aspektverhältnisses der Lochstrukturen kann die Zwischenschicht und die Barriereschicht nicht auf der gesamten Oberfläche der Lochstrukturen abgeschieden werden. Der Boden und der überwiegende Teil, insbesondere der untere Bereich der Zwischenwände der Lochstrukturen bleibt frei von der Zwischenschicht und der Barriereschicht. Sie verhindern jedoch den direkten Kontakt von Aluminium und Silizium.

Das Verfahren ist besonders vorteilhaft einsetzbar zur Herstellung eines Kontaktes für einen Kondensator, der in einem Siliziumsubstrat realisiert ist, dessen Oberfläche durch elektrochemisches Ätzen in einem fluoridhaltigen, sauren Elektrolyten, in dem das Substrat als Anode verschaltet ist, vergrößert ist und auf dessen vergrößerter Oberfläche eine dielektrische Schicht und eine dotierte Polysiliziumschicht als Gegenelektrode angeordnet sind. Die Oberfläche des Siliziumsubstrats weist Lochstrukturen mit einem Aspektverhältnis bis zu 1:1000 auf, die sich auch auf die Oberfläche der dotierten Polysiliziumschicht übertragen. In diesem Fall muß zur Kontaktierung der dotierten Polysiliziumschicht ein aluminiumhaltiger Kontakt hergestellt werden, der eine geschlossene planare Oberfläche aufweist, die z. B. mit Wire-bonding-Verfahren kompatibel ist. Dieser Kontakt ist durch Herstellung einer planaren aluminiumhaltigen Schicht nach dem erfindungsgemäßen Herstellverfahren und Strukturierung dieser Schicht herstellbar. Der Kontakt wird dabei planar aber trotzdem dünn und daher kostengünstig hergestellt.

Ein weiterer Vorteil des erfindungsgemäßen Verfahrens ist, daß die Lochstruktur durch die aluminiumhaltige Schicht abgeschlossen und damit abgedeckt ist. Bei der Montage und dem weiteren Fertigungsprozeß ist die Lochstruktur durch diese Abdeckung geschützt.

Die geschlossene planare aluminiumhaltige Schicht kann in nachfolgenden Fertigungsschritten z. B. als Kontakt strukturiert werden. Nach einer solchen Strukturierung kann die aluminiumhaltige Schicht als Ätzmaske für spätere Ätzungen verwendet werden. Dieses ist z. B. bei der Anwendung des Verfahrens zur Herstellung eines Kontaktes für den Kondensator vorteilhaft einsetzbar zur Strukturierung der dotierten Polysiliziumschicht. Durch Verwendung des fertig strukturierten Kontaktes, der eine geschlossene planare Oberfläche aufweist, als Ätzmaske werden bei der Strukturierung der dotierten Polysiliziumschicht Schwierigkeiten vermieden, die mit der Herstellung einer Fotolackmaske auf der Oberfläche des Substrats mit den Lochstrukturen verbunden wären.

Ein weiterer Vorteil des erfindungsgemäßen Verfahrens besteht darin, daß die Schichtabscheidung durch kostengünstiges, fertigungserprobtes DC-Magnetron-Sputtern möglich ist. Das erfindungsgemäße Verfahren ist sowohl für reine Aluminiumschichten als auch für elektromigrationsresistente verdünnte Aluminiumlegierungen, z. B. Aluminium mit einem Gewichtsprozent Silizium und 0,5 Gewichtsprozent Cu geeignet.

Weitere Ausgestaltungen der Erfindung gehen aus den übrigen Ansprüchen hervor.

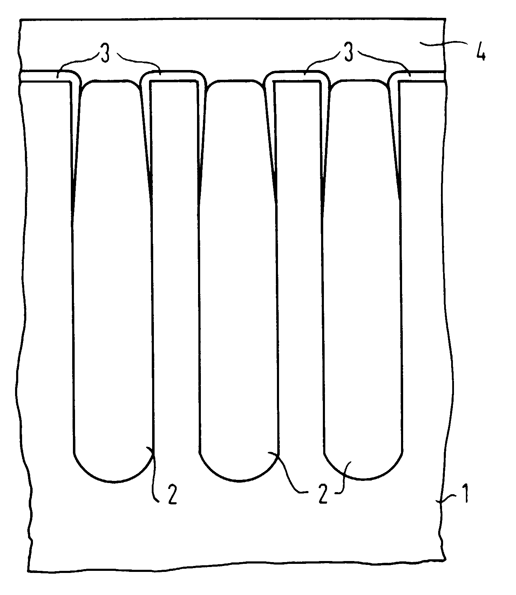

Im folgenden wird die Erfindung anhand der Figur und eines Ausführungsbeispiels näher erläutert.

Die Figur zeigt ein Substrat mit einer Lochstruktur, an dessen Oberfläche eine planare, Al-haltige Schicht hergestellt ist.

Ein Substrat 1, das z. B. n-dotiert ist, monokristallines Silizium enthält, ist mit Lochstrukturen 2 versehen. Die Lochstrukturen 2 sind z. B. durch elektrochemisches Ätzen in einem fluoridhaltigen, sauren Elektrolyten, in dem das Substrat 1 als Anode verschaltet ist, hergestellt. Die Lochstrukturen 2 weisen ein Aspektverhältnis von z. B. 1:100 auf. An der Oberfläche der Lochstrukturen 2 kann eine dielektrische Schicht und darauf eine dotierte Polysiliziumschicht angeordnet sein (nicht dargestellt).

Bei einer Temperatur des Substrats 1 von z. B. 200 bis 400 °C wird durch reaktives Sputtern eine Schichtenfolge 3 aus reinem Titan mit einer Dicke von z. B. 20 bis 30 nm und aus TiN mit einer Dicke von z. B. 100 bis 150 nm hergestellt. Das Ti/TiN schlägt sich auf den zwischen den Lochstrukturen angeordneten Zwischenwänden nieder. Es verjüngt die zylindrischen Lochstrukturen 2 zu ihrem oberen Ende hin. Die Schichtenfolge 3 bildet jedoch keine, die Lochstrukturen 2 verschließende durchgehende Schicht.

Bei einer Substrattemperatur von z. B. 400 bis 500 °C wird im Vakuum mit einem Restgaspartialdruck von weniger als 1,3 x 10⁻⁵ Pa (10⁻⁷ Torr), bei einem Druck des Sputter-gases von z. B. 1,3 x 10⁻² Pa bis 13 Pa und einer Abscheiderate von z. B. 1 µm pro Minute in einem Sputterverfahren eine Al-haltige Schicht 4 abgeschieden. Unter diesen Prozeßbedingungen ist eine hohe Oberflächenbeweglichkeit sichergestellt, so daß sich eine durchgehende, planare Schicht ausbildet. Bei einer Schichtdicke von 1 µm bis 3 µm verschließt die Al-haltige Schicht 4 die Lochstrukturen 2, die einen Durchmesser von z. B. 0,5 bis 2 µm aufweisen, vollständig. Die Al-haltige Schicht 4 ist von dem Silizium des Substrats 1 durch die Schichtenfolge 3 aus Ti/TiN getrennt. Dadurch wird eine Ausbildung von Spiking zwischen dem Aluminium und dem Silizium vermieden.

## Patentansprüche

1. Verfahren zur Herstellung einer Al-haltigen Schicht mit einer planaren Oberfläche auf einem Substrat mit Lochstrukturen mit einem hohen Aspektverhältnis von mindestens 10 in der Oberfläche,
- bei dem die Al-haltige Schicht (4) in einem Sputterverfahren auf der die Lochstrukturen enthaltenden Oberfläche des Substrats (1) abgeschieden wird, wobei das Substrat (1) auf erhöhter Temperatur gehalten wird,
- bei dem das Sputterverfahren bei einem Druck zwischen 1,3 x 10⁻² Pa und 13 Pa und einem geringen Restgaspartialdruck durchgeführt wird.

2. Verfahren nach Anspruch 1,
bei dem die Lochstrukturen ein Aspektverhältnis im Bereich zwischen 50 und 200 aufweisen.

3. Verfahren nach Anspruch 1 oder 2,
bei dem die Oberfläche der Lochstrukturen elektrisch leitfähig ist.

4. Verfahren nach einem der Ansprüche 1 bis 3,
bei dem das Substrat (1) während der Abscheidung der Al-haltigen Schicht (4) auf einer Temperatur zwischen etwa 400 °C und 500 °C gehalten wird.

5. Verfahren nach einem der Ansprüche 1 bis 4,
bei dem im Vakuum ein Restgaspartialdruck von weniger als 1,3 x 10⁻⁵ Pa herrscht.

6. Verfahren nach einem der Ansprüche 1 bis 5,
bei dem die Al-haltige Schicht (4) durch DC-Magnetron-Sputtern hergestellt wird.

7. Verfahren nach einem der Ansprüche 1 bis 6,
bei dem das Substrat (1) an der Oberfläche Silizium aufweist.

8. Verfahren nach einem der Ansprüche 1 bis 7,
bei dem auf das Substrat (1) zunächst eine Zwischenschicht aus reinem Titan und eine Barriereschicht aus TiN (3) abgeschieden wird, auf die die aluminiumhaltige Schicht (4) abgeschieden wird.

9. Verfahren nach Anspruch 8,
bei dem die Zwischenschicht in einer Dicke zwischen 20 und 30 nm und die Barriereschicht in einer Dicke zwischen 100 und 150 nm bei einer Substrattemperatur zwischen 200 und 400 °C abgeschieden wird.

10. Anwendung eines Verfahrens nach einem der Ansprüche 1 bis 9 zur Herstellung einer Al-haltigen Schicht mit planarer Oberfläche auf der Oberfläche eines n-dotierten Siliziumsubstrats, in der durch elektrochemisches Ätzen in einem fluoridhaltigen, sauren Elektrolyten, in dem das Siliziumsubstrat als Anode verschaltet ist, Lochstrukturen gebildet worden sind.

11. Anwendung eines Verfahrens nach einem der Ansprüche 1 bis 9 zur Herstellung einer Al-haltigen Schicht mit planarer Oberfläche als Kontakt für einen Kondensator, der ein n-dotiertes Siliziumsubstrat, in dessen Oberfläche durch elektrochemisches Ätzen in einem fluoridhaltigen, sauren Elektrolyten, in dem das Siliziumsubstrat als Anode verschaltet ist, Lochstrukturen gebildet sind, eine dielektrische Schicht, die an der Oberfläche der Lochstrukturen angeordnet ist, und eine dotierte Polysiliziumschicht, die an der Oberfläche der dielektrischen Schicht angeordnet ist und die die Form der Lochstrukturen aufweist, umfaßt, wobei die Al-haltige Schicht auf die Oberfläche der Polysiliziumschicht aufgebracht wird.

## Claims

1. Method for producing an Al-containing layer having a planar surface on a substrate having hole structures with a high aspect ratio of at least 10 in the surface,
- in which the Al-containing layer (4) is deposited in a sputtering process on the surface of the substrate (1) that contains the hole structures, the substrate (1) being kept at an elevated temperature,
- in which the sputtering process is carried out at a pressure of between 1.3 x 10⁻² Pa and 13 Pa and a small residual gas partial pressure.

2. Method according to Claim 1,
in which the hole structures have an aspect ratio in the range between 50 and 200.

3. Method according to Claim 1 or 2,
in which the surface of the hole structures is electrically conductive.

4. Method according to one of Claims 1 to 3,
in which the substrate (1) is kept at a temperature of between about 400 °C and 500 °C during the deposition of the Al-containing layer (4).

5. Method according to one of Claims 1 to 4,
in which a residual gas partial pressure of less than 1.3 x 10⁻⁵ Pa prevails in the vacuum.

6. Method according to one of Claims 1 to 5,
in which the Al-containing layer (4) is produced by DC magnetron sputtering.

7. Method according to one of Claims 1 to 6,
in which the substrate (1) has silicon on the surface.

8. Method according to one of Claims 1 to 7,
in which the substrate (1) has deposited onto it first of all an intermediate layer made of pure titanium and a barrier layer made of TiN (3), onto which the aluminium-containing layer (4) is deposited.

9. Method according to Claim 8,
in which the intermediate layer is deposited to a thickness of between 20 and 30 nm and the barrier layer to a thickness of between 100 and 150 nm at a substrate temperature of between 200 and 400 °C.

10. Application of a method according to one of Claims 1 to 9 for producing an Al-containing layer having a planar surface on the surface of an n-doped silicon substrate, in which hole structures have been formed by electrochemical etching in a fluoride-containing, acidic electrolyte in which the silicon substrate is connected up as the anode.

11. Application of a method according to one of Claims 1 to 9 for producing an Al-containing layer having a planar surface as contact for a capacitor comprising an n-doped silicon substrate, in whose surface hole structures are formed by electrochemical etching in a fluoride-containing, acidic electrolyte in which the silicon substrate is connected up as the anode, a dielectric layer, which is arranged on the surface of the hole structures, and a doped polysilicon layer, which is arranged on the surface of the dielectric layer and has the form of the hole structures, the Al-containing layer being applied to the surface of the polysilicon layer.

## Revendications

1. Procédé pour la préparation d'une couche à teneur en Al possédant une surface plane, sur un substrat dont les structures de trous possèdent un rapport d'aspect élevé d'au moins 10 dans la surface,
- dans lequel la couche (4) à teneur en Al est précipitée dans un procédé de crépitation sur la surface du substrat (1) contenant les structures de trous, le substrat (1) étant maintenu à une température élevée,
- dans lequel le procédé de crépitation est réalisé sous une pression entre 1,3 x 10⁻² Pa et 13 Pa et sous une pression partielle de gaz résiduel minime.

2. Procédé selon la revendication 1,
dans lequel les structures de trous présentent un rapport d'aspect dans le domaine entre 50 et 200.

3. Procédé selon la revendication 1 ou 2,
dans lequel la surface des structures de trous est électroconductrice.

4. Procédé selon l'une quelconque des revendications 1 à 3,
dans lequel le substrat (1), au cours de la précipitation de la couche (4) à teneur en Al, est maintenu à une température entre environ 400°C et 500°C.

5. Procédé selon l'une quelconque des revendications 1 à 4,
dans lequel, dans le vide, règne une pression partielle de gaz résiduel inférieure à 1,3 x 10⁻⁵ Pa.

6. Procédé selon l'une quelconque des revendications 1 à 5,
dans lequel on prépare la couche (4) à teneur en Al via des dispositifs de crépitation utilisant un magnétron en courant continu.

7. Procédé selon l'une quelconque des revendications 1 à 6,
dans lequel le substrat (1) présente du silicium sur sa surface.

8. Procédé selon l'une quelconque des revendications 1 à 7,
dans lequel, sur le substrat (1), on précipite d'abord une couche intermédiaire en titane pur et une couche d'arrêt en TiN (3) sur laquelle on précipite la couche (4) à teneur en aluminium.

9. Procédé selon la revendication 8,
dans lequel on précipite la couche intermédiaire en une épaisseur entre 20 et 30 nm et la couche d'arrêt en une épaisseur entre 100 et 150 nm, à une température du substrat entre 200 et 400°C.

10. Utilisation d'un procédé selon l'une quelconque des revendications 1 à 9, pour la préparation d'une couche à teneur en Al possédant une surface plane sur la surface d'un substrat en silicium à dopage de type N, dans laquelle ont été formées des structures de trous par gravure électrochimique dans un électrolyte acide contenant du fluorure dans lequel le substrat contenant du silicium est mis en circuit sous forme d'anode.

11. Utilisation d'un procédé selon l'une quelconque des revendications 1 à 9, pour la préparation d'une couche à teneur en Al possédant une surface plane faisant office de contact pour un condensateur, qui comprend un substrat en silicium à dopage de type N à la surface duquel on a formé des structures de trous par gravure électrochimique dans un électrolyte acide contenant du fluorure dans lequel le substrat en silicium est mis en circuit sous forme d'anode, une couche diélectrique qui est disposée sur la surface des structures de trous et une couche de polysilicium dopé qui est disposée sur la surface de la couche diélectrique et qui présente la forme des structures de trous, la couche à teneur en Al étant appliquée sur la surface de la couche de polysilicium.
